# EUROPÄISCHE PATENTSCHRIFT

(11) **EP 1 205 094 B1**
(45) Veröffentlichungstag und Bekanntmachung des Hinweises auf die Patenterteilung: **05.02.2003**
(21) Anmeldenummer: 00960919.9
(22) Anmeldetag: 21.08.2000
(51) Int. Cl.: H05K 3/30, H01R 12/20, H01R 43/24, H01R 13/405

(54) **ZUR MONTAGE AUF EINE LEITERPLATTE AUSGELEGTES BAUTEIL**
COMPONENT FOR ASSEMBLY ON A PRINTED CIRCUIT BOARD
PIECE CONCUE POUR ETRE MONTEE SUR UNE CARTE DE CIRCUITS

(30) Priorität: 20.08.1999 DE 19939584
(43) Veröffentlichungstag der Anmeldung: 15.05.2002
(73) Patentinhaber: TYCO Electronics Logistics AG, 9323 Steinach (CH)
(72) Erfinder: VANBESIEN, Johan, B-8902 Ieper (BE)
(74) Vertreter: Hirsch, Peter, Dipl.-Ing.
(86) Internationale Anmeldenummer: IB0001377
(87) Internationale Veröffentlichungsnummer: WO01015503

(56) Entgegenhaltungen:
- EP-A- 0 784 359
- US-A- 4 986 772
- US-A- 5 104 827
- US-A- 5 236 375

## Beschreibung

Die vorliegende Erfindung betrifft eine Vorrichtung gemäß dem Oberbegriff des Patentanspruchs 1, d.h. ein zur Montage auf eine Leiterplatte ausgelegtes Bauteil, mit einer Vielzahl von mit der Leiterplatte zu verbindenden elektrischen Anschlußelementen.

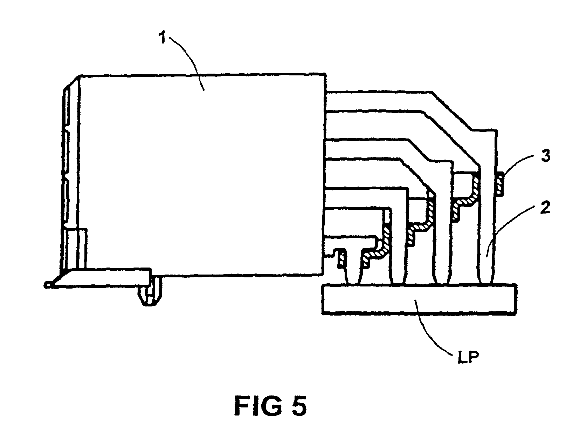

Ein solches Bauteil ist beispielsweise der in Figur 5 gezeigte elektrische Verbinder. Der gezeigte elektrische Verbinder besteht im wesentlichen aus in der Figur 5 nicht gezeigten Kontaktelementen zum Verbinden des elektrischen Verbinders mit einem anderen elektrischen Verbinder, einem die Kontaktelemente umgebenden Gehäuse 1, aus dem Gehäuse 1 herausgeführten elektrischen Anschlußelementen 2 zum Verlöten des elektrischen Verbinders mit einer Leiterplatte LP, und einer Ausrichtplatte 3.

Durch die Ausrichtplatte 3 werden die elektrischen Anschlußelemente 2 des elektrischen Verbinders in einer vorbestimmten Relativlage gehalten. Bezüglich weiterer Einzelheiten zur Ausrichtplatte 3 wird auf die DE 197 54 877 A1 verwiesen.

Das Halten der elektrischen Anschlußelemente in einer vorbestimmten Relativlage ist insbesondere dann von Vorteil, wenn es sich bei dem elektrischen Verbinder um ein zur Oberflächenmontage ausgelegtes Bauteil handelt, die elektrischen Anschlußelemente also sogenannte SMT-Kontakte sind.

SMT-Kontakte sind dazu ausgelegt, mit Oberflächenkontakten der Leiterplatte verlötet zu werden. Dabei wird zunächst auf die Oberflächenkontakte der Leiterplatte eine Lötpaste aufgetragen, dann wird das mit der Leiterplatte zu verlötende Bauteil auf die Leiterplatte aufgesetzt, und schließlich erfolgt das eigentliche Verlöten durch Erhitzen der betreffenden Stellen.

Damit ein ordnungsgemäßes Verlöten erfolgt, müssen die mit den Oberflächenkontakten der Leiterplatte zu verlötenden Stellen der elektrischen Anschlußelemente des elektrischen Verbinders während des Erhitzens mit der Lötpaste in Kontakt stehen; anderenfalls kann verständlicherweise keine Lötverbindung zwischen den Oberflächenkontakten der Leiterplatte und den elektrischen Anschlußelementen des elektrischen Verbinders zustande kommen.

Aus diesem Grund müssen die zu verlötenden Stellen der elektrischen Anschlußelemente eines Bauteils ungefähr in einer Ebene liegen. Gegebenenfalls vorhandene Abweichungen von der Koplanarität dieser Stellen sind nur in einem sehr geringem Umfang tolerierbar.

Die ist insbesondere bei Bauteilen mit sehr vielen elektrischen Anschlußelementen ein ernsthaftes Problem.

Zur Beseitigung dieses Problems werden die elektrischen Anschlußelemente von zur Oberflächenmontage ausgelegten Bauteilen nicht selten durch die erwähnte Ausrichtplatte 3 in ihrer bestimmungsgemäßen Relativlage fixiert. Dadurch kann erreicht werden, daß die zu verlötenden Stellen aller elektrischen Anschlußelemente in einer Ebene liegen.

Daß die elektrischen Anschlußelemente eines Bauteils eine genau vorgeschriebene Relativlage einnehmen, kann auch bei Bauteilen erforderlich sein, die nicht zur Oberflächenmontage ausgelegt sind. Auch in diesem Fall kann sich der Einsatz einer Ausrichtplatte oder dergleichen als vorteilhaft erweisen.

Allerdings sind die Herstellung und insbesondere die Montage solcher Ausrichtplatten mit einem nicht unerheblichen Aufwand verbunden.

Document US-A-5 236 375 beschreibt einer Verbinder nach dem Oberbegriff des Anspruchs 1.

Der vorliegenden Erfindung liegt daher die Aufgabe zugrunde, das Bauteil gemäß dem Oberbegriff des Patentanspruchs 1 derart weiterzubilden, daß sich dessen elektrische Anschlußelemente mit minimalem Aufwand zuverlässig und dauerhaft exakt in einer vorbestimmten Relativlage fixieren lassen.

Diese Aufgabe wird erfindungsgemäß durch Patentanspruch 1 gelöst.

Demnach ist vorgesehen, daß mehrere elektrische Anschlußelemente durch einen an diese angespritzten Kunststoffkörper in einer vorbestimmten Relativlage fixiert werden.

Das Fixieren der Anschlußelemente in einer vorbestimmten Relativlage durch Anspritzen eines Kunststoffkörpers an die zuvor ausgerichteten Anschlußelemente läßt sich erheblich leichter bewerkstelligen als die Herstellung und die Montage einer Ausrichtplatte oder dergleichen. Außerdem sind durch einen angespritzen Kunststoffkörper fixierte Anschlußelemente erheblich genauer und sicherer fixiert als es bei der Verwendung von Ausrichtplatten oder dergleichen der Fall ist.

Bei einem wie beansprucht ausgebildeten Bauteil sind die elektrischen Anschlußelemente mit minimalem Aufwand zuverlässig und dauerhaft exakt in einer vorbestimmten Relativlage fixierbar.

Vorteilhafte Weiterbildungen der Erfindung sind den Unteransprüchen, der nachfolgenden Beschreibung und den Figuren entnehmbar.

Die Erfindung wird nachfolgend anhand von Ausführungsbeispielen unter Bezugnahme auf die Figuren näher erläutert. Es zeigen
- Figur 1: eine Seitenansicht des nachfolgend näher beschriebenen elektrischen Verbinders,
- Figur 2: eine Frontansicht des in Figur 1 gezeigten elektrischen Verbinders,
- Figur 3: eine Schnittansicht des in den vorhergehenden Figuren gezeigten elektrischen Verbinders (Schnitt längs der Linie III-III in Figur 2),
- Figur 4: eine Ansicht des in den vorhergehenden Figuren gezeigten elektrischen Verbinders von unten, und
- Figur 5: einen herkömmlichen elektrischen Verbinder.

Bei dem Bauteil, anhand dessen die Erfindung nachfolgend näher beschrieben wird, handelt es sich um einen elektrischen Verbinder. Es sei jedoch bereits an dieser Stelle darauf hingewiesen, daß die nachfolgend näher beschriebenen Besonderheiten des elektrischen Verbinders auch bei anderen Bauteilen vorgesehen werden können.

Der vorliegend näher betrachtete elektrische Verbinder weist eine Vielzahl von mit der Leiterplatte zu verlötenden elektrischen Anschlußelementen auf. Die nachfolgend näher beschriebenen Besonderheiten des elektrischen Verbinders lassen sich aber auch bei Bauteilen einsetzen, die anders als durch Verlöten mit der Leiterplatte verbunden werden.

Bei den mit der Leiterplatte zu verlötenden elektrischen Anschlußelementen handelt es sich im betrachteten Beispiel um zur Oberflächenmontage des Bauteils auf die Leiterplatte ausgelegte SMT-Kontakte. Die mit der Leiterplatte zu verlötenden elektrischen Anschlußelemente können aber auch zum Verlöten (Reflow-Löten, Wellenlöten etc.) in durchkontaktierten Löchern der Leiterplatte ausgebildete Anschlußelemente sein.

Ebenso wäre denkbar, daß die mit der Leiterplatte zu verlötenden elektrischen Anschlußelemente des Bauteils zum Verlöten derselben auf der gegenüberliegenden Seite der Leiterplatte ausgebildete Anschlußelemente sind.

Es sei bereits an dieser Stelle darauf hingewiesen, daß sich das Vorsehen der nachfolgend näher beschriebenen Besonderheiten bei Bauteilen, bei welchen die elektrischen Anschlußelemente durch SMT-Kontakte gebildet werden, besonders vorteilhaft auswirkt; positive Effekte lassen sich aber auch bei Bauteilen erzielen, deren elektrische Anschlußelemente zum Verlöten nach einem anderen Verfahren ausgelegt sind.

Der vorliegend näher betrachtete elektrische Verbinder entspricht insoweit dem eingangs unter Bezugnahme auf die Figur 5 beschriebenen elektrischen Verbinder.

Der vorliegend näher betrachtete Verbinder zeichnet sich insbesondere dadurch aus, daß mehrere elektrische Anschlußelemente durch einen an diese angespritzten Kunststoffkörper in einer vorbestimmten Relativlage fixiert werden.

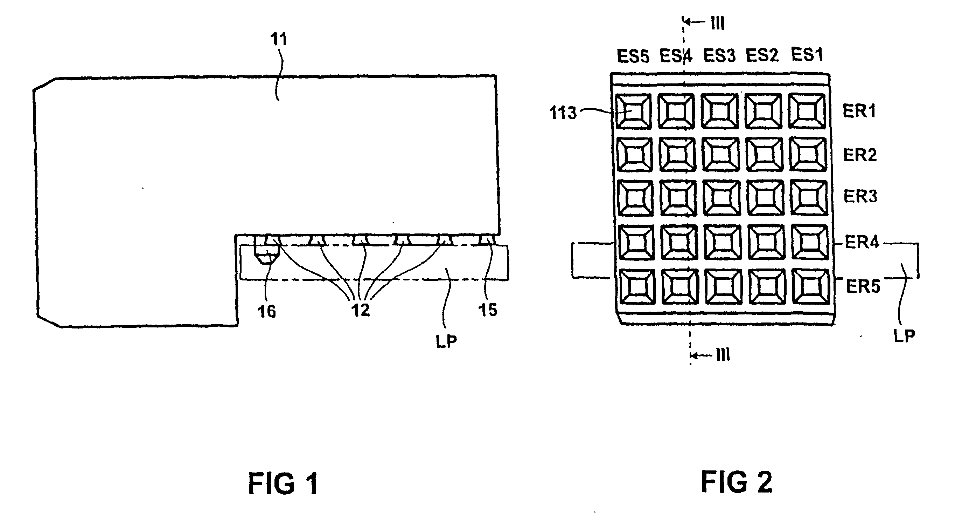

Dies wird nachfolgend unter Bezugnahme auf die Figuren 1 bis 4 näher beschrieben.

Die bereits erwähnten elektrischen Anschlußelemente des vorliegend betrachteten elektrischen Verbinders sind mit dem Bezugszeichen 12 bezeichnet. Im betrachteten Beispiel sind insgesamt 25 elektrische Anschlußelemente vorhanden. Diese sind so ausgebildet und angeordnet, daß sie mit einer auf der Leiterplatte vorgesehenen, 5 Reihen und 5 Spalten umfassenden Oberflächenkontakt-Matrix verlötbar sind. Es dürfte sich von selbst verstehen, daß sowohl die Anzahl als auch die Anordnung der elektrischen Anschlußelemente und der zugeordneten Oberflächenkontakte beliebig anders sein kann.

Der elektrische Verbinder enthält darüber hinaus noch ein Gehäuse 11, welches jedoch im Gegensatz zum Gehäuse 1 des elektrischen Verbinders gemäß Figur 5 nicht nur die zum Kontaktieren eines anderen elektrischen Verbinders erforderlichen Kontaktelemente, sondern auch den größten Teil der beim elektrischen Verbinder gemäß Figur 5 freiliegenden elektrischen Anschlußelemente beherbergt; von den elektrischen Anschlußelementen 12 ragen im wesentlichen nur noch die zum Verlöten mit der Leiterplatte vorgesehenen Stellen aus dem Gehäuse heraus.

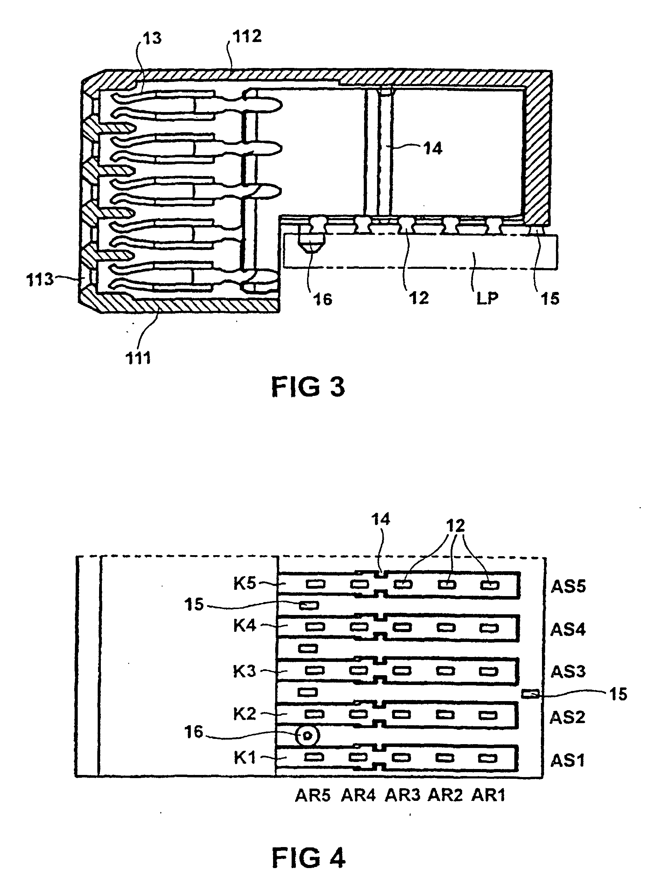

Wie insbesondere aus der Figur 3 ersichtlich ist, besteht das Gehäuse 11 im betrachteten Beispiel aus zwei Teilen nämlich einem Unterteil 111 und einem Oberteil 112.

Das Unterteil 111 und/oder das Oberteil 112 des Gehäuses 11 oder sonstige Bestandteile des elektrischen Verbinders können an einem oder mehreren Verankerungspunkten 15 mechanisch mit der Leiterplatte LP verbunden werden. An den Verankerungspunkten können die Gehäuseteile beispielsweise an die Leiterplatte angelötet werden, wobei dieses Verlöten bei oberflächenmontierbaren Bauteilen wie dem vorliegend betrachteten elektrischen Verbinder vorzugsweise ebenfalls nach einem SMT-Verfahren erfolgt. Eine derartige oder sonstige Verankerung des elektrischen Verbinders auf der Leiterplatte gibt diesem einen festen Halt; er kann bei mechanischer Beanspruchung nicht so leicht von der Leiterplatte abgelöst werden wie es ohne Verankerung der Fall wäre. Die Verankerungselemente können auch die Einnahme der bestimmungsgemäßen Lage des elektrischen Verbinders bei der Montage desselben auf die Leiterplatte erleichtern.

Zur genauen Positionierung des elektrischen Verbinders auf der Leiterplatte dienen im betrachteten Beispiel auch ein oder mehrere Positionierzapfen 16, die in zugeordnete Öffnungen in der Leiterplatte einzustecken sind.

In Figur 3 sind auch die zum Verbinden des elektrischen Verbinders mit einem anderen elektrischen Verbinder vorgesehenen Kontaktelemente desselben dargestellt; sie sind dort mit dem Bezugszeichen 13 bezeichnet. Die Kontaktelemente 13 sind hinter im Gehäuse 11 vorgesehenen Einstecköffnungen 113 angeordnet; über diese Einstecköffnungen können die Kontaktelemente des elektrischen Verbinders, mit dem der vorliegend betrachtete elektrische Verbinder in Kontakt gebracht werden soll, mit den Kontaktelementen 13 in Kontakt gebracht werden. Wie insbesondere aus Figur 2 ersichtlich ist, sind im betrachteten Beispiel insgesamt 25 Einstecköffnungen 113 vorgesehen; diese sind in einer 5 Reihen und 5 Spalten umfassenden Einstecköffnungs-Matrix angeordnet. Die Einstecköffnungs-Reihen verlaufen in horizontaler Richtung und werden durch seitlich nebeneinander angeordnete Einstecköffnungen gebildet; sie sind in den Figuren mit den Bezugszeichen ER1 bis ER5 bezeichnet. Die Einstecköffnungs-Spalten verlaufen in vertikaler Richtung und werden durch übereinander angeordnete Einstecköffnungen gebildet; sie sind in den Figuren mit den Bezugszeichen ES1 bis ES5 bezeichnet.

Die hinter den Einstecköffnungen 113 liegenden Kontaktelemente 13 sind mit den elektrischen Anschlußelementen 12 verbunden oder gehen in diese über. Die elektrischen Anschlußelemente, genauer gesagt deren mit der Leiterplatte zu verlötenden Stellen sind ebenfalls in einer aus 5 Reihen und 5 Spalten bestehenden Matrix angeordnet. Dies ist insbesondere aus Figur 4 ersichtlich. Die Anschlußelement-Reihen sind dabei mit den Bezugszeichen AR1 bis AR5 bezeichnet, und die Anschlußelement-Spalten mit den Bezugszeichen AS1 bis AS5. Dabei sind jeweils die an einander entsprechenden Stellen innerhalb der jeweiligen Matrizen vorgesehenen Kontaktelemente und Anschlußelemente miteinander verbunden. D.h., ein hinter der m-ten Einstecköffnungs-Spalte und der n-ten Einstecköffnungs-Reihe vorgesehenes Kontaktelement ist mit dem in der m-ten Anschlußelement-Spalte und der n-ten Anschlußelement-Reihe vorgesehenen Anschlußelement verbunden.

Wie vorstehend bereits erwähnt wurde, muß bei SMT-Bauteilen wie dem vorliegend betrachteten elektrischen Verbinder dafür gesorgt werden, daß die mit der Leiterplatte zu verlötenden Stellen der elektrischen Anschlußelemente koplanar sind.

Dies wird im betrachteten Beispiel dadurch erreicht, daß die in eine entsprechende Relativlage gebrachten elektrischen Anschlußelemente mit Kunststoff umspritzt werden. Dabei bildet sich um die Anschlußelemente ein gemeinsamer Kunststoffkörper aus, durch welchen die diesen durchlaufenden Anschlußelemente in ihrer zum Zeitpunkt des Umspritzens eingenommenen Relativlage fixiert werden. Der Vollständigkeit halber sei darauf hingewiesen, daß die mit der Leiterplatte zu verlötenden Stellen der Anschlußelemente selbstverständlich nicht mit umspritzt werden; der die umspritzten Anschlußelemente umgebende Kunststoffkörper ist so angeordnet und bemessen, daß er die Montage des elektrischen Bauteils auf die Leiterplatte nicht behindert.

Je nach Bedarf können alle Anschlußelemente oder nur bestimmte Anschlußelemente wie beschrieben umspritzt werden. Die zu umspritzenden Anschlußelemente können dabei durch einen für alle Anschlußelemente gemeinsamen Kunststoffkörper oder durch mehrere einzelne Kunststoffkörper fixiert werden.

Im betrachteten Beispiel wird von der zuletzt genannten Möglichkeit Gebrauch gemacht. Dabei werden die Anschlußelemente jeweils spaltenweise umspritzt. Dies erweist sich als besonders vorteilhaft, weil die Anschlußelemente einer Anschlußelement-Spalte auch gemeinsam hergestellt werden können: die jeweils in einer Spalte angeordneten Anschlußelemente können (vorzugsweise zusammen mit den zugeordneten Kontaktelementen) gemeinsam aus einem einzigen Blechteil gestanzt und geformt werden. Das Umspritzen der gemeinsam (im selben Arbeitsgang) hergestellten Anschlußelemente gestaltet sich besonders einfach, weil diese dadurch unmittelbar nach ihrer Herstellung weiterverarbeitet werden können.

Die Anschlußelemente des vorliegend betrachteten elektrischen Verbinders werden dadurch spaltenweise durch jeweils eigene Kunststoffkörper fixiert. Diese Kunststoffkörper sind lamellenartige Gebilde und sind in den Figuren mit K1 bis K5 bezeichnet.

Dadurch, daß "nur" immer jeweils diejenigen Anschlußelemente über einen gemeinsamen Kunststoffkörper verbunden werden, die in den selben Arbeitsgängen gemeinsam hergestellt werden, und dadurch, daß das Umspritzen der Anschlußelemente mit Kunststoff unmittelbar nach deren Herstellung erfolgen kann, können die Anschlußelemente in der Relativlage fixiert werden, in welcher sie ausgestanzt wurden. Stanzt man die Anschlußelemente so aus, daß sie nach dem Ausstanzen die gewünschte Relativlage einnehmen, so können die Anschlußelemente durch das anschließende Umspritzen ohne eine vorherige Justierung in der gewünschten Relativlage fixiert werden.

Wenn die Anschlußelemente wie im betrachteten Beispiel unabhängig voneinander durch mehrere separate Kunststoffkörper in gewünschten Relativlagen fixiert werden, erweist es sich als günstig, wenn die Kunststoffkörper vorzugsweise an einer zentralen Stelle mit Strukturen versehen sind, unter Verwendung welcher die mehreren Kunststoffkörper und damit alle Anschlußelemente des elektrischen Verbinders in eine vorbestimmte Relativlage gebracht werden können.

Im betrachteten Beispiel werden die besagten Strukturen durch vertikal verlaufende Nuten 14 in den Kunststoffkörpern K1 bis K5 gebildet. In diese Nuten können durch das Aufsetzen des Oberteils 112 des Gehäuses 11 in diesem vorgesehene Elemente wie beispielsweise vertikal verlaufende Zwischenwände, Stege, Zapfen, Stifte und dergleichen eingeführt werden. Dadurch können die Kunststoffkörper seitlich zueinander ausgerichtet werden.

Insbesondere bei sehr großen (viele Spalten aufweisenden elektrischen Verbindern oder sonstigen Bauteilen) kann es sich als günstig erweisen, wenn die wie beschrieben oder anders erfolgende Ausrichtung der Kunststoffkörper nicht deren Begehbarkeit senkrecht zur Leiterplattenoberfläche einschränkt. Dann können sich die Kunststoffkörper mit den sie durchlaufenden Anschlußelementen - angetrieben durch ihr Eigengewicht - unabhängig voneinander unterschiedlich weit nach unten bewegen und so in der Leiterplatte vorhandene Unebenheiten ausgleichen.

Bei einem wie beschrieben ausgebildeten Bauteil ist es unabhängig von den Einzelheiten der praktischen Realisierung möglich, die elektrischen Anschlußelemente mit minimalem Aufwand zuverlässig und dauerhaft exakt in einer vorbestimmten Relativlage zu fixieren.

## Patentansprüche

1. Zur Montage auf eine Leiterplatte (LP) ausgelegter elektrischer Verbinder mit einer Vielzahl von mit der Leiterplatte zu verbindenden elektrischen Anschlußelementen (12), angeordnet als eine je mehrere Reihen und Spalten aufweisende Matrix,
**dadurch gekennzeichnet,**
**daß** die Anschlußelemente von mehreren jeweils mehrere mit der Leiterplatte zu verlötende, als SMT-Kontakte ausgebildete Anschlußelemente (12) umfassenden Anschlußelemente-Gruppen unabhängig voneinander durch eigene angespritzte Kunststoffkörper (K1-K5) in einer vorbestimmten Relativlage fixiert sind, und daß die Kunststoffkörper mit den die durchlaufenden Anschlußelemente-Gruppen unabhängig voneinander senkrecht zur Leiterplatten-Oberfläche bewegbar sind.

2. Verbinder nach Anspruch 1,
**dadurch gekennzeichnet,**
**daß** der Kunststoffkörper (K1-K5) mit den ihn durchlaufenden Anschlußelementen (12) relativ zu bestimmten oder allen restlichen Bestandteilen des Verbinders bewegbar sind.

3. Verbinder nach Anspruch 1 oder 2,
**dadurch gekennzeichnet,**
**daß** die Anschlußelemente (12) der Anschlußelemente-Gruppen jeweils solche Anschlußelemente sind, die gemeinsam hergestellt werden.

4. Verbinder nach einem der Ansprüche 1 bis 3,
**dadurch gekennzeichnet,**
**daß** die Anschlußelemente (12) der Anschlußelemente-Gruppen jeweils solche Anschlußelemente sind, die an zueinander benachbarten Stellen mit der Leiterplatte (LP) zu verbinden sind.

5. Verbinder nach einem der vorhergehenden Ansprüche,
**dadurch gekennzeichnet,**
**daß** die die jeweiligen Kunststoffkörper (K1-K5) durchlaufenden Anschlußelemente (12) jeweils die einzigen Bestandteile des Verbinders sind, mit denen die Kunststoffkörper verbunden sind.

## Claims

1. Electrical connector designed to be fitted onto a printed-circuit board (LP) and comprising a large number of electrical connecting elements (12) which are arranged as a matrix comprising a plurality of respective rows and columns and are to be connected to the printed-circuit board, **characterised in that** the connecting elements of a plurality of connecting element groups each comprising a plurality of connecting elements (12) which are to be soldered to the printed-circuit board and are formed as SMT contacts are fixed independently of one another in a predetermined relative position by dedicated moulded-on plastic bodies (K1-K5) and **in that** the plastic bodies can be moved with the connecting element groups passing through them, independently of one another, perpendicularly to the surface of the printed-circuit board.

2. Connector according to claim 1, **characterised in that** the plastic body (K1-K5) with the connecting elements (12) passing through it can be moved relative to specific components or all other components of the connector.

3. Connector according to claim 1 or 2, **characterised in that** the connecting elements (12) of the connecting element groups are those respective connecting elements which are produced together.

4. Connector according to any one of claims 1 to 3, **characterised in that** the connecting elements (12) of the connecting element groups are those respective connecting elements which are to be connected to the printed-circuit board (LP) at mutually adjacent points.

5. Connector according to any one of the preceding claims, **characterised in that** the connecting elements (12) passing through the respective plastic bodies (K1-K5) are the respective single components of the connector to which the plastic bodies are connected.

## Revendications

1. Connecteur électrique destiné à être monté sur une carte de circuits (LP), comportant de nombreux éléments de raccordement électriques (12) devant être raccordés à la carte de circuit, agencés sous forme d'une matrice comportant respectivement plusieurs rangées et colonnes, **caractérisé en ce que** les éléments de raccordement de plusieurs groupes d'éléments de raccordement comportant respectivement plusieurs éléments de raccordement (12) devant être soudés sur la carte de circuits et ayant la forme de contacts SMT sont fixés indépendamment dans une position relative prédéterminée par des corps en matière plastique respectifs formés par extrusion (K1-K5), les corps en matière plastique et les groupes des éléments de raccordement qui les traversent pouvant être déplacés indépendamment et perpendiculairement à la surface de la carte de circuits.

2. Connecteur selon la revendication 1, **caractérisé en ce que** le corps en matière plastique (K1-K5) et les éléments de raccordement qui le traversent (12) peuvent effectuer un déplacement relatif par rapport à des composants définis ou par rapport à tous les composants restants du connecteur.

3. Connecteur selon les revendications 1 ou 2, **caractérisé en ce que** les éléments de raccordement (12) des groupes d'éléments de raccordement sont respectivement constitués par des éléments de raccordement fabriqués ensemble.

4. Connecteur selon l'une des revendications 1 à 3, **caractérisé en ce que** les éléments de raccordement (12) des groupes d'éléments de raccordement sont respectivement des éléments de raccordement devant être raccordés à la carte de circuits (LP) au niveau d'emplacements avoisinants.

5. Connecteur selon l'une des revendications précédentes, **caractérisé en ce que** les éléments de raccordement (12) traversant les corps en matière plastique respectifs (K1-K5) constituent respectivement les seuls composants du connecteur auxquels les corps en matière plastique sont raccordés.
